**Europäisches Patentamt**

**European Patent Office**

**Office européen des brevets**

(19)

(11) Veröffentlichungsnummer: **0 154 696**
**B 1**

(12)

# EUROPÄISCHE PATENTSCHRIFT

(45) Veröffentlichungstag der Patentschrift:
03.06.87

(51) Int. Cl.⁴: **C 23 C 14/54**

(21) Anmeldenummer: **84115078.2**

(22) Anmeldetag: **10.12.84**

(54) **Verfahren zur Kontrolle und Regelung der Zusammensetzung und der Schichtdicke von metallisch leitenden Legierungsschichten während ihrer Herstellung.**

(30) Priorität: **16.02.84 DE 3405559**

(43) Veröffentlichungstag der Anmeldung:
**18.09.85 Patentblatt 85/38**

(45) Bekanntmachung des Hinweises auf die Patenterteilung:
**03.06.87 Patentblatt 87/23**

(84) Benannte Vertragsstaaten:
**AT CH DE FR GB IT LI NL SE**

(56) Entgegenhaltungen:
**EP - A - 0 033 507**
**EP - A - 0 067 432**
**DE - A - 1 590 698**

**PATENTS ABSTRACTS OF JAPAN, Band 2, Nr. 131, 31. Oktober 1978, Seite 2719 C 78**

(73) Patentinhaber: **Siemens Aktiengesellschaft Berlin und München, Wittelsbacherplatz 2, D-8000 München 2 (DE)**

(72) Erfinder: **Hieber, Konrad, Dr. rer. nat., Laubensteinstrasse 7, D-8214 Bernau (DE)**
Erfinder: **Mayer, Nobert, Dr. rer. nat., Werdenfelserstrasse 77, D-8000 München 70 (DE)**

ACTORUM AG

## Beschreibung

Die Patentanmeldung betrifft ein Verfahren zur Kontrolle und Regelung der Zusammensetzung und der Schichtdicke von metallisch leitenden Legierungsschichten während ihrer Herstellung durch elektrische Widerstandsmessung, wobei die einzelnen Legierungskomponenten zeitlich nacheinander zyklisch lagenweise abgeschieden werden.

Die genaue Kenntnis der Zusammensetzung und der Dicke von Schichten, die durch Aufdampfen oder Aufstäuben, zum Beispiel durch gleichzeitiges Zerstäuben von zwei oder mehreren Targets («Co-Sputtern»), hergestellt werden, ist für die Fertigung von Dünnschichtschaltungen bzw. integrierten Schaltungen von grosser Bedeutung.

Während die Zusammensetzung sehr empfindlich die elektrischen und metallkundlichen Eigenschaften (zum Beispiel Diffusion, Reaktion) beeinflusst, ist bei Schichten, die zum Beispiel als Widerstand oder Ätzbarriere eingesetzt werden, auch die Kenntnis der Dicke wesentlich. Im Zuge der fortschreitenden Miniaturisierung in der Halbleitertechnologie sind die Toleranzen bezüglich Zusammensetzung und Dicke sehr eng geworden, so dass eine Messung und Steuerung dieser beiden Grössen bereits bei der Schichtherstellung unerlässlich ist, um eine genügend hohe Ausbeute zu erreichen.

Bei     Chrom-Nickel-Dünnschicht-Widerständen wird der Temperaturkoeffizient des elektrischen Widerstandes, der zum Beispiel im Bereich von $-25$ bis $+25 \times 10^{-6}$/K liegen muss, sehr empfindlich von der Zusammensetzung beeinflusst. Um diese Werte reproduzierbar einhalten zu können, darf die Konzentration nur um $\pm$ 3% Atomzahlanteil schwanken. Da ausserdem von diesem Material noch eine hohe Stabilität gefordert wird, die wiederum von der Menge des in die Schicht eingebauten Sauerstoffs abhängt, muss auch die Sauerstoffkonzentration gesteuert werden.

Schliesslich wird aus der ganzflächig abgeschiedenen Schicht mittels eines Fotoätzprozesses eine Widerstandsstruktur mit einem eng tolerierten Widerstandswert erzeugt. Die Schichtdickenschwankungen müssen dabei unter $\pm$ 3% liegen.

Auch bei Tantal-Silizium-Schichten, die in der VLSI-Technologie unter anderem als niederohmiges Gatematerial bzw. als Leiterbahnen eingesetzt werden, wird der spezifische elektrische Widerstand stark von der Zusammensetzung beeinflusst. Ferner besitzen nur Schichten mit einer bestimmten Konzentration die Eigenschaft, in einer oxidierenden Atmosphäre bei Temperaturen um 900°C eine $SiO_2$-Schutzschicht zu bilden. Auch in diesem Fall erhält man nur dann ein reproduzierbares Oxidwachstum, wenn die Zusammensetzung nur geringfügig ($\pm$ 2% Atomzahlanteil) um einen festen Wert schwankt.

Um bezüglich Schichtdicke und Zusammensetzung homogene Schichten zu erhalten, ist es bekannt, die für die Beschichtung vorgesehenen Substrate während der Beschichtung zu bewegen (zum Beispiel Rotation, Planetenbewegung). Da ferner moderne Beschichtungsanlagen sehr oft eine Schleuse besitzen, über die die Substrate in die eigentliche Beschichtungskammer eingeführt werden, ist das Substrat nicht ortsfest, wodurch eine in situ-Bestimmung der Schichtdicke bzw. der Zusammensetzung sehr erschwert wird. Eine Möglichkeit, die Schichtdicke zu bestimmen, ist die, an einem ortsfesten Substrat, das mit elektrischen Kontakten versehen ist, und das gleichzeitig mit den übrigen bewegten Substraten beschichtet wird, den Widerstand zu messen. Hierzu wird zum Beispiel auf einen Aufsatz von S. C. P. Lim und D. Ridley in Solid State Technology, February 1983, auf den Seiten 99 bis 103 und auf einen Aufsatz von I. A. Turner et. al. in J. Sci. Instrum. 1963, Vol. 40, Seiten 557 bis 561 hingewiesen.

Eine weitere Methode besteht darin, einen oder mehrere ortsfeste Quarzoszillatoren, deren Resonanzfrequenz sich mit zunehmender Messenbewegung durch ein aufgedampftes oder aufgestäubtes Material definiert ändert, in der Anlage zu installieren.

Der Nachteil der genannten Verfahren ist, dass aufgrund der unterschiedlichen örtlichen Lage zwischen Substrat und Oszillator bzw. Referenzsubstrat eine Eichung durchgeführt werden muss.

Will man die Zusammensetzung zum Beispiel einer binären Legierungsschicht mit Hilfe von Quarzoszillatoren steuern, so muss gewährleistet sein, dass mindestens zwei Schwingquarze in der Anlage montiert sind, wobei jeder Oszillator nur von einer Quelle beschichtet wird. Aus dem Verhältnis der momentanen Massenbelegung kann auf die Zusammensetzung der Schicht geschlossen werden.

Eine weitere, sehr genaue Möglichkeit, die Schichtzusammensetzung zu regeln, besteht darin, ein Massenspektrometer einzusetzen, bei dem das von beiden Verdampferquellen stammende Material in die Ionenquelle gelangt und registriert wird. Auch hier besteht der Nachteil, dass die Ionenquelle ortsfest ist und für die Schichtdickenbestimmung ein Schwingquarz benötigt wird. Ferner ist diese Methode in Sputteranlagen nicht anwendbar bzw. zu ungenau, da die Abscheidung bei einem Argon-Druck von ca. $10^{-2}$ mbar erfolgt.

Aufgabe der Erfindung ist es daher, für die Herstellung von Legierungsschichten, bei der die Legierungskomponenten oder Vorlegierungen nicht kontinuierlich, sondern zeitlich nacheinander, das heisst lagenweise auf das Substrat aufgebracht werden, ein Verfahren anzugeben, das es erlaubt, die Legierungszusammensetzung und die Gesamtschichtdicke während der Beschichtung zu bestimmen, Änderungen in der Legierungszusammensetzung noch während des Schichtherstellungsprozesses zu erfassen und gemäss den festgestellten Änderungen die Raten der einzelnen Materialquellen so zu verändern, dass wieder die gewünschte Legierungszusammensetzung oder Endschichtdicke erreicht wird. Eine weitere Aufgabe ist, dieses Verfahren auf die Herstellung von Schichten, deren Konzentration sich mit der Schichtdicke kontinuierlich oder diskontinuierlich ändert, und auf die Herstellung von Legierungsschichten mit definierten Zwischenschichten anzuwenden.

Diese Aufgabe wird durch ein Verfahren der eingangs genannten Art dadurch gelöst, dass

a) der Schichtwiderstand vor und nach dem Abscheiden jeder einzelnen Lage (A, B) gemessen und dabei der Lagenwiderstand bzw. des Verhältnis der Lagenwiderstände von Schichten mit unterschiedlichem Material als Istwert bestimmt wird,

b) der Lagenwiderstand verglichen wird mit dem vor der Schichtherstellung festgelegten Wert des Lagenwiderstandes bzw. des Verhältnisses der Lagenwiderstände als Sollwert und

c) bei Soll-Istwert-Differenzen die Beschichtungsraten der entsprechenden Legierungskomponentenquellen (A, B) so lange verändert werden, bis die Istwerte mit den Sollwerten übereinstimmen.

Das erfindungsgemässe Verfahren besteht in einer Regelung der einzelnen Beschichtungsquellen, wobei fortlaufend die Istwerte der Regelgrösse ( = wahlweise Lagenwiderstand oder Verhältnis der Lagenwiderstände der einzelnen Lagen aus unterschiedlichem Material) bestimmt (gemessen) werden, mit den festgelegten Werten der Lagenwiderstände ( = Sollwert, Stellgrösse) verglichen werden und bei Soll-Istwert-Differenzen die Rate der Beschichtungsquelle (als Stellgrösse) so verstellt wird, dass die Werte der Regelgrösse an die Werte der Stellgrösse angeglichen werden.

Wird für die Stellgrösse ein von Lage zu Lage sich stetig oder unstetig verändernder Wert verwendet, ist es möglich, Legierungsschichten mit einer sich über die Schichtdicke kontinuierlich oder diskontinuierlich ändernden Zusammensetzung herzustellen.

Wenn die Schichtzusammensetzung nur kontrolliert werden soll, werden lediglich die oben beschriebenen Istwerte der Regelgrössen während der Schichtherstellung erfasst. Eine Regelung findet dann nicht statt. Nach der Schichtherstellung ist dann bereits ohne weitere Untersuchung der Schicht bekannt, ob die hergestellte Schicht insbesondere die gewünschten elektrischen Eigenschaften besitzt. Dieses im Vergleich zur Regelung eingeschränkte Verfahren der Kontrolle ist für eine Fertigung bereits von grosser Bedeutung, da bei der Herstellung eines Halbleiterbauelements eine Vielzahl von Folgeschritten unterbleiben kann, wenn man bereits nach der Beschichtung weiss, dass die aufgebrachte metallische Schicht nicht «gut» ist.

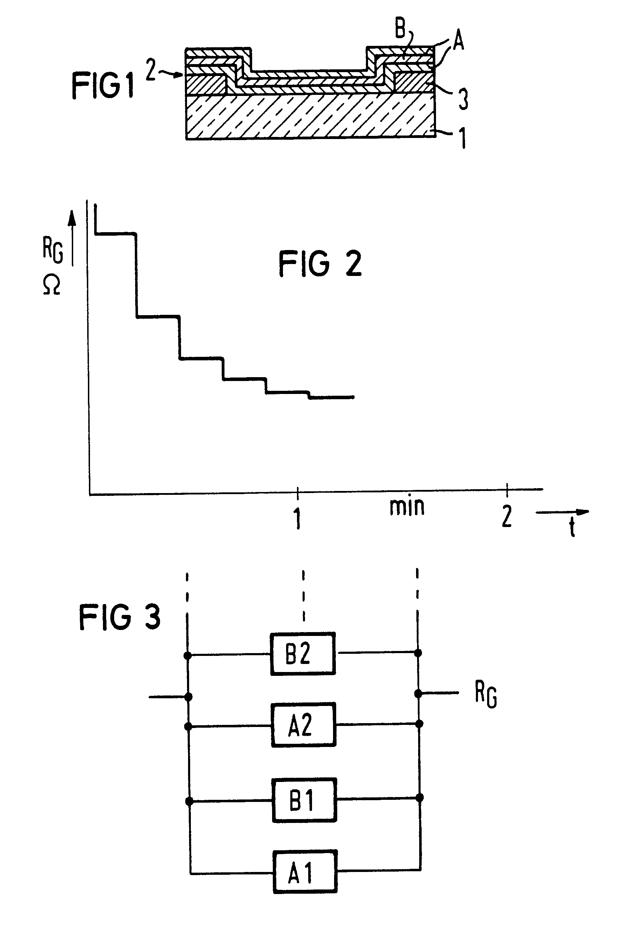

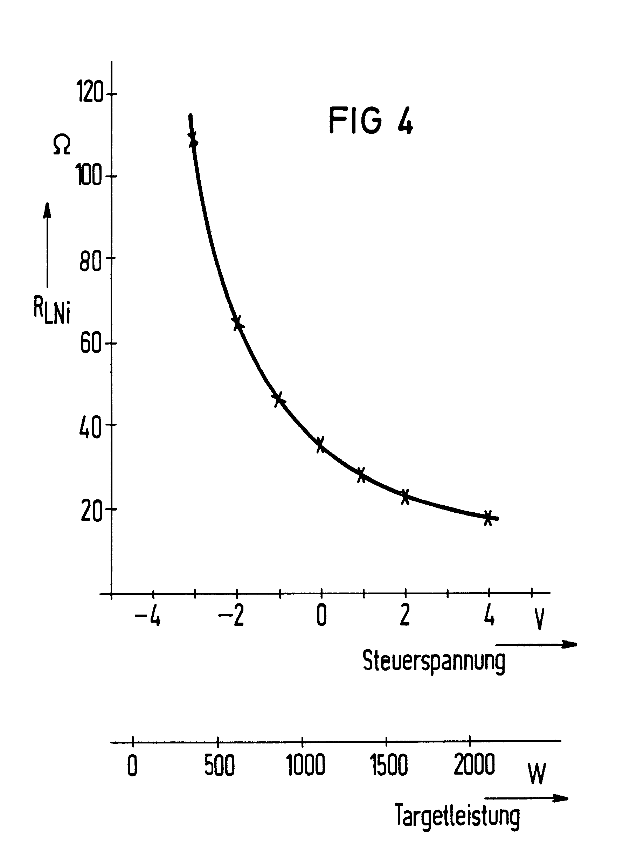

Weitere Einzelheiten und Vorteile des erfindungsgemässen Verfahrens werden im folgenden anhand von Ausführungsbeispielen und der in der Zeichnung befindlichen Figuren 1 bis 4 noch näher erläutert. Dabei zeigen

die Fig. 1 den Aufbau einer Mehrlagenschicht auf ein elektrisch isolierendes Substrat mit Kontakten,

die Fig. 2 den Verlauf des Gesamtwiderstandes $R_G$ beim Aufbringen einer Mehrlagenschicht in Abhängigkeit von der Zeit t,

die Fig. 3 ein Ersatzschaltbild für eine Mehrlagenschicht mit der Schichtfolge A, B, A, B . . . . . und

die Fig. 4 in einem Kurvendiagramm den Zusammenhang zwischen Targetleistung bzw. Steuerspannung und Lagerwiderstand für Nickel.

*Figur 1:*

Bei den Legierungsschichten für das erfindungsgemässe Verfahren werden die einzelnen Legierungskomponente oder -partner (Vorlegierungen) alternierend aufgebracht. Zum Beispiel bei einer binären Legierung AB werden die beiden Legierungspartner A und B von getrennten Quellen (zum Beispiel Targets) aus so auf das Substrat 1 aufgebracht, dass die Schicht 2 zunächst aus einer Vielzahl von Lagen A, B, A, B . . . usw. besteht. A und B können die reinen Elemente, zum Beispiel Cr und Ni oder auch Vorlegierungen sein, zum Beispiel Al/Si = A und Ti = B zur Herstellung von Al/Si/Ti Leiterbahnen bzw. Ta/Si = A und Ta = B zur Herstellung von $TaSi_2$-Gatematerial oder Leiterbahnen. Mit dem Bezugszeichen 3 ist der elektrische Kontakt bezeichnet.

Die Herstellung kann derart erfolgen, dass die beiden Materialquellen örtlich getrennt sind und das Substrat in periodischen Zeitabständen an beiden Quellen vorbei geführt wird, wie zum Beispiel in einem Aufsatz von K. Hieber in den Siemens Forsch. und Entw. Ber. Bd. 11 (1982) Nr. 3, Seiten 145 bis 148, beschrieben ist. Eine andere Möglichkeit besteht beim Verdampfen mit einem Elektronenstrahl. Der Strahl oszilliert zwischen zwei Materialquellen, wobei durch die Verweildauer bei einem Material die Lagendicke und damit die Schichtzusammensetzung beeinflusst werden kann. Eine weitere Möglichkeit ist es, die Materialquellen wechselweise durch eine Blende abzudecken. Um durch Tempern ein homogenes Material erzeugen zu können, empfiehlt es sich, eine möglichst geringe Lagendicke (zum Beispiel 1 bis 150 nm, bevorzugt kleiner 50 nm) zu wählen.

*Figur 2:*

Misst man bei den beschriebenen Beschichtungsverfahren den Widerstand auf dem Substrat kontinuierlich während der Schichtherstellung, so erhält man einen stufenförmigen Widerstandsverlauf, da jede Lage A oder B den momentanen Gesamtwiderstand um einen diskreten Betrag erniedrigt. Diese stufenförmige Messwertfolge kann mit Hilfe eines Rechners schnell und fortlaufend analysiert werden, um die Widerstandserniedrigung durch die einzelne Lage zu bestimmen. Eine andere Möglichkeit ist es, eine Messung des elektrischen Schichtwiderstandes vor und nach dem Durchgang der Schicht unter der Beschichtungsquelle durchzuführen, wobei der Zeitpunkt für die einzelnen Messungen von aussen, zum Beispiel durch die Stellung der Palette in bezug auf ein Relais so festgelegt wird, dass sich die Probe gerade ausserhalb des Beschichtungsbereiches befindet.

Aus der Widerstandsänderung von Stufe zu Stufe lässt sich der Widerstand einer Lage berechnen, der — abgesehen von der ersten Lage — bei konstanten Herstellbedingungen einen festen Wert annimmt.

*Figur 3:*

Elektrisch kann diese Schichtfolge durch eine Reihe von Parallelschaltungen von Widerständen, wobei ein Widerstand dem Widerstand $R_{Ln}$ einer Lage entspricht, dargestellt werden.

Für den Fall, dass ein Material zum Beispiel aus zwei Beschichtungsquellen (A, B) hergestellt wird, errechnet sich der Gesamtwiderstand $R_G$ nach der Formel:

$$\frac{1}{R_{Gn,m}} = \frac{1}{R_{A1}} + \frac{1}{R_{B1}} + \frac{1}{R_{A2}} + \frac{1}{R_{B2}} + \ldots \ldots$$
$$\ldots \ldots + \frac{1}{R_{Am}} + \frac{1}{R_{Bm}} + \frac{1}{R_{An}} + \frac{1}{R_{Bn}} + \ldots \ldots \qquad \text{I}$$

Bei Schichten mit konstanter Konzentration in Abhängigkeit von der Schichtdicke sind die Widerstände der Lagen von Material A und Material B gleich, das heisst: $R_{A1} = R_{A2} = R_{An} = R_A$ bzw. $R_{B1} = R_{B2} = R_{Bn} = R_B$.

Besitzt der momentane Gesamtwiderstand eine Lage mehr an Material A so gilt — unter der Voraussetzung, dass A auch die erste Lage ist —

$$R_{Gn,m} = \frac{R_A \cdot R_B}{n\,R_B + mR_A} \quad \text{mit } m = n - 1 \qquad \text{II}$$

Bei gleicher Lagenzahl m an Material A und B gilt:

$$R_{Gm,m} = \frac{R_A \cdot R_B}{m\,(R_A + R_B)} \qquad \text{III}$$

Der Lagenwiderstand errechnet sich aus der Differenz zweier aufeinanderfolgender Gesamtwiderstände, wobei für den Lagenwiderstand einer n-ten Lage an Material A gemäss I und II gilt:

$$R_{LAn} = \frac{R_{Gm,m} \cdot R_{Gn,m}}{R_{Gm,m} - R_{Gn,m}} \qquad \text{IV}$$

Für den Lagenwiderstand einer n-ten Lage an Material B ergibt sich gemäss Formel I, II und III:

$$R_{LBn} = \frac{R_{Gn,n} \cdot R_{Gn,m}}{R_{Gn,m} - R_{Gn,n}} \qquad \text{IV}$$

Der Zusammenhang zwischen Widerstand R und Schichtdicke d ist durch die fundamentale Formel

$$R = \frac{\rho \cdot G}{d} \qquad \text{V}$$

gegeben, wobei $\rho$ den spezifischen elektrischen Widerstand und der Geometriefaktor G der Schicht das Verhältnis Länge I zu Breite b angibt. Im folgenden wird $I = b$ und damit $G = 1$ angenommen. Somit ergibt sich die Dicke einer Lage A aus

$$d_{LAn} = \frac{\rho_A}{R_{LAn}} \qquad \text{VI}$$

$\rho_A$ = spezifischer elektrischer Widerstand der Lage A und analog gilt für die Lage B:

$$d_{LBn} = \frac{\rho_B}{R_{LBn}} \qquad \text{VII}$$

Die momentane Gesamtschichtdicke ergibt sich dann aus der Summe aller $d_{LA}$ und $d_{LB}$.

Daraus folgt, dass jeder diskreten Abnahme des Gesamtwiderstandes eine bestimmte Schichtdicke der Lage A bzw. B zugeordnet werden kann, da $\rho_A$ bzw. $\rho_B$ nicht von der Lagenzahl abhängen. Die Werte für $\rho_A$ bzw. $\rho_B$ (Komponente oder Vorlegierungen) werden am besten in Vorversuchen mit nur einer Beschichtungsquelle bei den gewünschten Herstellbedingungen für die entsprechende Schichtdicke ermittelt. Einzelheiten sind aus einem Aufsatz von N. Mayer aus dem Siemens Forsch- und Entw. Ber. Bd. 11 (1982) Nr. 6, Seiten 322 bis 325, zu entnehmen.

Da der Dicke einer Lage wiederum eine gewisse Stoffmenge A bzw. B zugeordnet werden kann, ist das Verhältnis zweier aufeinanderfolgender Lagenwiderstände $R_{LAn}/R_{LBn}$ proportional der momentanen Schichtzusammensetzung $M_{Bn}/M_{An}$ = Konzentration $Z_n$.

$$M_{An} = d_{LAn} \cdot I \cdot b \cdot \gamma_A$$

$\gamma_A$ = Dichte des Materials A in $g/cm^3$

entsprechend gilt:

$$M_{Bn} = d_{LBn} \cdot I \cdot b \cdot \gamma_B$$

$\gamma_B$ = Dichte des Materials B in $g/cm^3$.

Die momentane Zusammensetzung $Z_n$ als Masseverhältnis — mit $I = b = 1$ — ist dann:

$$Z_n = \frac{d_{LBn} \cdot \gamma_B}{d_{LAn} \cdot \gamma_A}$$

Setzt man $\gamma_B/\gamma_A = P_0$, so ergibt sich

$$Z_n = P_0 \frac{d_{LBn}}{d_{LAn}}$$

Mit VI und VII gilt:

$$Z_n = P_0 \frac{\rho_B R_{LAn}}{\rho_A R_{LBn}} \qquad\qquad P_1 = P_0 \frac{\rho_B}{\rho_A}$$

$$Z_n = P_1 \frac{R_{LAn}}{R_{LBn}} \qquad\qquad\qquad \text{VIII}$$

Da $P_1$ sich aus konstanten Grössen, die entweder in Vorversuchen bestimmt wurden ($\rho_A$, $\rho_B$) bzw. aus Werkstofftabellen entnommen werden können ($\gamma_A$, $\gamma_B$), zusammensetzt und somit bekannt ist, lässt sich aus VIII die momentan aufgebrachte Schichtzusammensetzung quantitativ während der Schichtherstellung aus dem Verhältnis der Lagenwiderstände bestimmen.

Sollten jedoch nur Änderungen in der Schichtzusammensetzung während der Herstellung festgelegt werden, genügt es, das Verhältnis der Lagenwiderstände zu bestimmen und die Werte untereinander oder mit vorgegebenen Sollwerten zu vergleichen, da die Proportionalitätsfaktoren konstante Materialgrössen sind, solange die Herstellbedingungen konstant sind, was Voraussetzung ist. Änderungen der Herstellbedingungen durch Fremdgaseinflüsse können insbesondere durch ein Massenspektrometer überwacht werden.

Ändert sich zum Beispiel die Beschichtungsrate für ein Material, so wird der entsprechende Lagenwiderstand kleiner oder grösser, je nachdem, ob zum Beispiel die Leistung an der Verdampfer- oder Zerstäuberquelle zu- oder abgenommen hat. Entsprechend wird $R_{LA}$ und/oder $R_{LB}$ oder das Verhältnis $R_{LA}/R_{LB}$ grösser oder kleiner ( = Istwerte).

Zur Kontrolle der Schichtzusammensetzung oder Gesamtschichtdicke reicht es aus, diese Istwerte fortlaufend zu bestimmen. Die Änderung einzelner Lagenwiderstände oder der Verhältnisse $R_{LA}/R_{LB}$ kann für eine Regelung verwendet werden in der Art, dass Legierungsschichten mit kontanter Gesamtzusammensetzung und -schichtdicke reproduzierbar hergestellt werden können, was für jede Fertigung von grundlegender Bedeutung ist.

Für die Regelung gibt es zwei Möglichkeiten:

a) Über die Änderung eines Lagenwiderstandes der n-ten Lage wird erkannt, welche Beschichtungsquelle geregelt werden muss und ob die Rate erhöht oder erniedrigt werden muss. Die entsprechende Beschichtungsquelle wird dann für einen Durchgang der Schicht (bei zwei Beschichtungsquellen wäre das die Lage n + 1) so verändert, dass, wenn vorher zu wenig Material aufgebracht wurde, das fehlende Material zusätzlich aufgebracht wird, oder, wenn vorher zu viel Material aufgebracht wurde, bei der neuen Lage entsprechend weniger Material aufgebracht wird, das heisst, der Materialausgleich erfolgt so, dass im Fall von zwei Beschichtungsquellen bei der n + 1-ten Lage der Materialausgleich für die n-te Lage erfolgt.

Der für die Regelung nötige Zusammenhang zwischen Änderung des aufgebrachten Lagenwiderstandes ($\triangleq$ Lagendicke) oder Konzentrationsänderung und Änderung der Leistung an der entsprechenden Beschichtungsquelle muss in Vorversuchen ermittelt werden.

Ist das Aufbringen der geänderten Lage wie gewünscht erfolgt, was durch die Bestimmung des Istwertes überprüft wird, wird die Beschichtungsquelle wieder so eingestellt, dass die momentane Schichtkonzentration wieder der gewünschten Schichtkonzentration entspricht, bei zwei Beschichtungsquellen ist das ab der n + 2-ten Lage wieder der Fall.

Ist dagegen das Aufbringen der geänderten Lage nicht wie gewünscht erfolgt, so wird auch bei der oder den folgenden Lagen ein Materialausgleich durchgeführt. Der Materialausgleich erfolgt durch Änderung der Beschichtungsrate der zu regelnden Materialquelle, was vorzugsweise durch Änderung der Leistung der Energieversorgung dieser Materialquelle erfolgt.

Dieses Verfahren der Regelung hat den Vorteil, dass neben dem gewünschten Effekt der konstanten Gesamtzusammensetzung auch die Gesamtschichtdicke konstant bleibt. Die Inhomogenitäten durch die unterschiedlichen Lagendicken einzelner Teilschichten werden durch die Materialdiffusion beim späteren Tempern der Schichten zum Zwecke der Homogenisierung ausgeglichen.

b) Eine zweite Art der Regelung ist die, dass die momentane Schichtkonzentration, die aufgebracht wird, immer der gewünschten Gesamtkonzentration entspricht. Bei Soll-Istwert-Differenzen wird dann die Leistung der zunächst konstanten Beschichtungsquelle an die Leistung der sich ändernden Beschichtungsquelle angepasst, derart, dass die momentane Zusammensetzung immer gleich der Gesamtkonzentration ist. Da sich die Lagendicken hierbei ändern, muss gegen Ende der Beschichtung anhand des Gesamtwiderstandes entschieden werden, ob die Gesamtlagenzahl grösser oder kleiner gewählt werden muss, um einen bestimmten Gesamtwiderstand bzw. Gesamtdicke zu erhalten. Im Gegensatz zur ersten Art der Regelung findet kein sofortiger Ausgleich an zu viel oder zu wenig angebrachtem Material statt.

Diese Verfahren der Regelung der Schichtzusammensetzung ermöglichen es auch, statt dem Ziel, eine konstante, homogene Schichtzusammensetzung zu erzielen, Schichten mit variabler Konzentration herzustellen:

a) Es ist möglich, kontinuierliche Änderungen der Schichtzusammenstellung über die Dicke herzustellen. Hierbei sind die Lagenwiderstände $R_{LA}$ bzw. $R_{LB}$ nicht mehr konstant, sondern sind eine Funktion der Lagenzahl n, das heisst, zum Beispiel bei zwei Beschichtungsquellen $R_{LAm} \neq R_{LAn}$. Die einzelnen Lagenwiderstände oder ihre Änderung müssen vorgegeben werden. Von Lage zu Lage wird dann die Leistung an den einzelnen Beschichtungsquellen neu eingestellt, zum Teil unter Berücksichtigung des gemessenen und ermittelten Materialüberschusses oder -defizites der vorhergehenden Lage, in der Art wie oben bereits beschrieben. Konzentrationsgradienten in Legierungsschichten sind sehr gut geeignet, um zum Beispiel eine bessere Haftung auf dem Substratmaterial zu erzielen, oder um zum Beispiel an der Schichtoberfläche eine leichtere Ausbildung von Passivierungsschichten zu ermöglichen. Zum Beispiel ist bei Cr/Ni-Schichten eine chromreiche Anfangsschicht zur Verbesserung der Haftung wünschenswert, während bei $TaSi_2$-Schichten eine siliziumreiche Endschicht die Ausbildung einer $SiO_2$-Passovierungsschicht fördert.

b) Es ist auch möglich, diskontinuierliche Änderungen der Schichtzusammensetzung gezielt herzustellen, wie zum Beispiel für Zwischenschichten. In diesem Falle wird zum Beispiel bis zur n-ten Lage die Schicht nur aus einem Material hergestellt. Ab der n + 1-ten Schicht wird die andere Beschichtungsquelle mit einem konstanten Wert zugeschaltet. Die Regelung erfolgt wie oben beschrieben.

Alle bisher aufgezeigten Lösungen und Anwendungen eignen sich besondere für die Fälle, wo keine Diffusion der Materialien ineinander erfolgt.

Im Falle von Diffusionen der Teilschichten ineinander bereits während des Schichtaufbringens sind immer noch stufenförmige Abnahmen des Widerstandes zu messen, die jedoch nicht mehr so scharfe Konturen zeigen. In diesem Fall sind die einzelnen Lagenwiderstände nicht mehr so genau bestimmbar, so dass es günstiger ist, den Widerstand unmittelbar vor und nach dem Aufbringen einer Lage zu messen und die Differenz zur Berechnung des Lagenwiderstandes zu verwenden. Aus dem Verhältnis der Lagenwiderstände kann dann zwar nicht mehr die momentane Schichtkonzentration quantitativ bestimmt werden, da $\rho_{Ln}$ als Folge der Diffusion nicht mehr durch das Material einer Beschichtungsquelle allein bestimmt wird. Da jedoch $\rho_{Ln}$ der entsprechenden

Teilschichten konstant ist, kann wiederum das Verhältnis der Lagenwiderstände verwendet werden, um Änderungen in der momentanen Schichtzusammensetzung festzustellen, so dass die oben beschriebenen Regelungsmethoden wieder anwendbar sind, um die beschriebenen Anwendungen zu realisieren.

Soll eine Legierungsschicht hergestellt werden, wobei eine Komponente ein halbleitendes Material ist, zum Beispiel Silizium, so können die oben beschriebenen Verfahren direkt oder in modifizierter Form verwendet werden. Das ist der Fall bei der Herstellung von Metallsiliziden, zum Beispiel als Gatematerial (Ta-Si, W-Si, Ti-Si, Mo-Si, Pd-Si usw.). Von der einen Beschichtungsquelle wird hierbei das Metall abgetragen, von der anderen das Silizium, so dass die Schicht aus einer Vielzahl von Metall-Halbleiter-Lagen besteht. Da Metall-Halbleiterkombinationen bereits während der Herstellung relativ rasch ineinander diffundieren, erhält man auch in diesem Fall eine Kurve für den Gesamtwiderstand, die diskrete Widerstandsänderungen aufweist. Auch in diesem Fall ist es möglich, Änderungen in der momentanen Schichtzusammensetzung festzustellen, bei Abweichungen die Raten an den entsprechenden Materialquellen zu ändern und somit die Schichtzusammensetzung zu regeln.

Auch die Anwendung der beschriebenen Regelungsverfahren auf die Herstellung von Schichten mit kontinuierlichen und diskontinuierlichen Konzentrationsänderungen in der Schicht ist möglich.

Eine weitere Lösung — bei der die beschriebenen Regelungsmöglichkeiten direkt übernommen werden können — ist die, eine Vorlegierung aus Metall/Halbleiter zu verwenden, wobei die Zusammensetzung der Vorlegierung einen höheren Anteil an Halbleitermaterial aufweist als in der gewünschten Schicht. Das Defizit der Metallkomponente wird durch die zweite Materialquelle — die zum Beispiel aus reinem Metall besteht — kompensiert, wobei das Metall in einer solchen Lagendicke eingelagert wird, dass die Doppellage AB die gewünschte Zusammensetzung besitzt. Im Falle der Herstellung von $TaSi_2$-Schichten würde zum Beispiel eine Vorlegierung aus Ta-Si mit einem Massenanteil von 20% Ta im Si einen spezifischen elektrischen Widerstand von ca. 700 $\mu\,\Omega$ cm besitzen. Dieses Material wäre zum Beispiel als Komponente A zusammen mit reinem Tantal als Komponente B ($\delta_{Ta} \approx 250\ \mu\,\Omega$ cm) bestens geeignet, $TaSi_2$-Schichten reproduzierbar zu erzeugen, da sich beim lagenweisen Aufbringen der Materialien eine saubere, stufenförmige Widerstandserniedrigung ergibt.

Bisher wurde davon ausgegangen, dass jede Materialquelle eine eigene Leistungsregelung mit Energieversorgung besitzt, so dass die Rate an jeder Materialquelle unabhängig von der anderen einstellbar ist.

Ein Spezialfall ist es, wenn bei der Verwendung von zum Beispiel zwei Beschichtungsquellen, beide zusammen eine gemeinsame Energieversorgung besitzen und die Leistung auf die beiden Beschichtungsquellen über einen «Teiler» aufgeteilt wird. Beim «Cosputtern», wobei die Targets durch Gleichspannungszerstäuben abgetragen werden, wird die Spannung — ausgehend von einer gemeinsamen Gleichspannungsquelle, zum Beispiel über ein Potentiometer, dessen Wert genau bestimmbar ist, auf die Tagets entsprechend der gewünschten Legierungszusammensetzung aufgeteilt.

Beim Hochfrequenz-Dioden-Zerstäuben (HF-Sputtern) wird ebenfalls nur ein Hochfrequenzgenerator verwendet, wobei die Leistungsaufteilung über einen Regel-Kondensator und -Spule erfolgt. In diesen Fällen kann die Rate der einzelnen Beschichtungsquellen über die Gesamtrate und die Leistungsaufteilung geregelt werden, das heisst wenn die Rate von einer Beschichtungsquelle vergrössert wird, wird automatisch die Rate der anderen Beschichtungsquelle verkleinert und umgekehrt. Bei einer Änderung der Gesamtrate bleibt die Leistungsaufteilung konstant, das heisst, das Konzentrationsverhältnis bleibt konstant.

Diese Art der Energieversorgung der Beschichtungsquellen ist dann bevorzugt zu verwenden, wenn die Widerstandsänderung, hervorgerufen durch eine Materialart (zum Beispiel Silizium) so klein ist, dass eine direkte Steuerung dieser Materialquelle sehr ungenau würde.

Im Falle der «gekoppelten» Beschichtungsquellen ist es dann bevorzugtes Ziel der Regelung, immer möglichst die gewünschte Schichtkonzentration zu halten. Zum Beispiel bei einer Metall-Halbleiter-Kombination:

Für die Regelung der Schichtdicke wird nur der Lagenwiderstand der Metallschicht verwendet, der durch Steuerung der Leistungsabgabe der gemeinsamen Energieversorgung auf seinen Sollwert eingeregelt werden kann. Die Zusammensetzung bleibt bei dieser Art der Regelung unbeeinflusst. Der Lagenwiderstand, hervorgerufen durch den Halbleiter, ist für die Regelung von untergeordneter Bedeutung.

*Ausführungsbeispiele:*

Die elektrischen Widerstandsmessungen werden während der Schichtherstellung mit einer «in-situ-Widerstandsmessvorrichtung» durchgeführt, wie sie in Siemens Forsch.- und Entw. Ber. Bd. 11 (1982), Seiten 322 bis 326, und in der Europ. Pat. Anm. 0 067 432 A1 beschrieben ist. Die Schichtherstellung erfolgt in einer Sputteranlage vom Typ Randex 4400 durch sogenanntes «Cosputtern» von zwei Targets, wie es zum Beispiel in Siemens Forsch.- und Entw. Ber. Bd. 11 (1982), Seiten 145 bis 148 beschrieben ist. Während der Beschichtung wird das Referenzsubstrat sowie die übrigen Substrate unter den Targets hindurchgedreht. Die elektrischen Widerstandswerte werden drahtlos aus der Sputteranlage an einen Empfänger übertragen und von dort von einem Rechner MINC 23 von Digital Equipment übernommen. Bei der Messung des Schichtwiderstandes wird der Einfluss des Sputterplasmas auf die Schicht berücksichtigt. An der Achse der Drehplatte ist ein Reedrelais montiert, so dass der Rechner die Widerstandswerte immer an festgelegten Stellen übernimmt: vor und nach dem 1. Target, vor und nach dem 2. Target. Hieraus kann der Rechner die Lagenwiderstände $R_{Ln}$ und die Verhältnisse $R_{Ln}/R_{Lm}$ ermitteln. Zur Regelung der Leistung der Targets ( = Rate) gibt der Rechner über zwei Digital-Analog-Wandler Steuerspannungen zwischen –5 und + 5 V aus, mit denen die Leistungsversorgung der Targets einzeln variiert werden können, oder im Falle der gekoppelten Targets die Gesamtleistung und die Leistungsverteilung verändert werden kann. Als Vorversuche werden stets unter den späteren Herstellungsbedingungen der Lagenwiderstand und somit $\rho_L$ für jedes einzelne Material bestimmt. (Versuch mit nur einem Target). Desweiteren wird der Zusammenhang zwischen Änderungen des aufgebrachten Lagenwiderstandes und den ± 5 V Steuerspannungen ($\triangleq$ Änderung der Leistung am Target $\triangleq$ Änderung der Sputterrate) bestimmt.

*Ausführungsbeispiel 1:* Cr-Ni-Legierungsschichten

Im folgenden wird die Kontrolle und Regelung anhand der Herstellung einer Cr-Ni-Widerstandsschicht genauer erläutert. Die Schichten werden durch sogennanntes Cosputtern abgeschieden, wobei die Drehzahl 1 U/min beträgt. Die gewünschte Zusammensetzung sollte $M_{Cr}/M_{Ni}$ = 47/53% (Massenanteil) betragen. Nimmt man die aus der Literatur bekannten Dichtewerte für Cr und Ni, so ergibt sich für das Schichtdickenverhältnis:

$$d_{Cr}/d_{Ni} = M_{Cr}/M_{Ni} \cdot \frac{\gamma_{Ni}}{\gamma_{Cr}} \qquad \gamma_{Ni} = 8,9 \text{ g/cm}^3 \text{ Cr}$$

$$d_{Cr}/d_{Ni} = 0,887 \cdot 1,24 = 1,1 \quad \gamma_{Cr} = 7,19 \text{ g/cm}^3$$

Im vorliegenden Beispiel wurde für Cr eine ideale Lagendicke von 5 nm und für Ni von 4,5 nm angestrebt.

Die Gesamtdicke der fertigen Schicht soll den Wert von 47,5 nm besitzen. Die aus Vorversuchen ermittelten spezifischen elektrischen Widerstände für Cr und Ni der entsprechenden Lagendicke betragen $\rho_{Cr}$ = 56,7 µ $\Omega$ cm bzw. $\rho_{Ni}$ = 16,2 µ $\Omega$ cm. Daraus errechnen sich — unter Vernachlässigung von Diffusions- bzw. Reaktionseffekten — die Lagenwiderstände (bei quadratischer Fläche) zu $R_{LCr}$ = 113,4 $\Omega$ bzw. $R_{LNi}$ = 36 $\Omega$ (Sollwerte) oder $R_{LCr}/R_{LNi}$ = $V_{Ln}$ = 3,15. Aufgrund der besseren Haftung von Cr auf oxidierten Substraten wurde als erste Lage Cr aufgebracht. Die gemessenen Werte des Gesamtwiderstandes sind in Tabelle 1 für den Idealfall aufgelistet. Die Messgenauigkeit beträgt für die Messbereiche 0 - 1 $\Omega$, 0 - 10 $\Omega$, 0 - 100 $\Omega$, 0 - 1000 $\Omega$ und 0 - 10 000 $\Omega$ jeweils ± 1‰.

Über die Formeln

$$d_{Cr}/d_{Ni} = \rho_{Cr}/\rho_{Ni} \cdot R_{LNi}/R_{LCr} =$$

$$= 3,5 \cdot \frac{1}{V_{Ln}} \quad \text{mit } V_{Ln} = \frac{R_{LCr}}{R_{LNi}}$$

und

$$d_{Cr}/d_{Ni} = M_{Cr}/M_{Ni} \cdot \gamma_{Ni}/\gamma_{Cr} = 1,24 \; M_{Cr}/M_{Ni}$$

kann der Zusammenhang zwischen Masseverhältnis (das heisst Konzentration) und Verhältnis der Lagenwiderstände hergestellt werden.

$$M_{Cr}/M_{Ni} = \frac{3,5}{1,24 \cdot V_{Ln}}$$

Der Massenanteil in % von zum Beispiel Chrom ergibt sich dann aus dem Verhältnis $M_{Cr}$ + $M_{Ni}$ und der Tatsache, dass die Summe $M_{Cr}$ + $M_{Ni}$ = 100% betragen.

Beispiel für Kontrolle:

| Lage | Gesamtwiderstand bei quadr. Fläche in $\Omega$ | | Istwert Lagenwiderstand $R_{Ln}$ in $\Omega$ | Verhältnis der Lagenwiderstände $V_{Ln}$ | Momentane Konzentration in Masse % Cr |
|------|--------|---------|------|------|------|
|      | vorher | nachher |      |      |      |
| Cr 1 | --- | 113,9 | 113,9 | 3,16 | 47,17 |
| Ni 1 | 113,9 | 27,4 | 36,08 | | |
| Cr 2 | 27,4 | 22,0 | 111,63 | 3,19 | 46,95 |
| Ni 2 | 22,0 | 13,5 | 34,94 | | |
| Cr 3 | 13,5 | 12,2 | 126,69 | 3,53 | 44,40 |
| Ni 3 | 12,2 | 9,10 | 35,81 | | |
| Cr 4 | 9,10 | 8,42 | 112,68 | 3,16 | 47,17 |
| Ni 4 | 8,42 | 6,81 | 35,61 | | |
| Cr 5 | 6,81 | 6,39 | 103,01 | 3,33 | 45,9 |
| Ni 5 | 6,39 | 5,30 | 31,07 | | |

Tabelle I: Gesamtwiderstand in Abhängigkeit von der Anzahl der aufgebrachten Cr- bzw. Ni-Lagen

Die Gesamtschichtdicke d ergibt sich aus der Summe aller $d_{Ln}$

$$d = \sum_{1}^{i=n} d_{Li} = \sum_{1}^{i=n} {}_{Li}/R_{Li} = 48,44 \text{ nm}$$

Steuerungsbeispiel:

In diesem Beispiel muss die Rate einer Beschichtungsquelle (Ni) von aussen beeinflusst werden, um die gewünschte Zusammensetzung zu erhalten.

a) Beim Lagenwiderstand Ni2 tritt eine kurzzeitige Änderung auf, so dass plötzlich statt des geforderten Sollwertes von 36 $\Omega$ ein Istwert von 29,86 $\Omega$ gemessen wird. Dabei ergibt sich ein Gesamtwiderstand von 12,7 statt von 13,6 $\Omega$. Das bedeutet, dass die Beschichtungsrate für Ni angestiegen ist.

Tabelle II zeigt nun den Verlauf der Regelung:

| Lage | Gesamtwiderstand bei quadr. Fläche in Ω | | Steuer-spannung in V | Istwert Lagenwiderstand in Ω | $V_{Ln}$ | Momentane Masse % Cr |
|---|---|---|---|---|---|---|
| | vorher | nachher | | | | |
| Cr 1 | --- | 113,0 | 0 | 113,0 | 3,14 | 47,34 |
| Ni 1 | 113,0 | 27,3 | 0 | 36,0 | | |
| Cr 2 | 27,3 | 22,1 | 0 | 116,0 | 3,88 | 42,12 |
| Ni 2 | 22,1 | 12,7 | 0 | 29,86 | | |
| Cr 3 | 12,7 | 11,42 | 0 | 113,4 | 2,53 | 52,67 |
| Ni 3 | 11,42 | 9,1 | −0,9 | 44,79 | | |
| Cr 4 | 9,10 | 8,42 | 0 | 112,68 | 3,09 | 47,74 |
| Ni 4 | 8,42 | 6,84 | −0,1 | 36,45 | | |
| Cr 5 | 6,84 | 6,44 | 0 | 110,12 | 3,11 | 47,59 |
| Ni 5 | 6,44 | 5,45 | 0 | 35,45 | | |

Tabelle II: Gesamtwiderstand in Abhängigkeit von der Anzahl der aufgebrachten Cr- bzw. Ni-Lagen

Die Regelung erfolgt nun derart, dass das Cr mit konstanter Rate weiterläuft, während für Ni3 die Leistung der Ni-Quelle derart reduziert wird, dass der Lagenwiderstand 44,79 Ω beträgt und der Gesamtwiderstand wieder identisch ist mit dem normalen Verlauf (vergleiche Tabelle I und II). Für Ni4 wird dann die Leistung wieder so hoch geregelt, dass der Lagenwiderstand 36 Ω beträgt.

*Figur 4:*
Der Zusammenhang zwischen der Änderung der Sputterrate oder des Lagenwiderstandes und einer Änderung der Leistung am Target (Steuerspannung) wird in Vorversuchen für die Drehzahl von 1 U/min ermittelt. Die Sputterrate für Ni beträgt bei einer Leistung von 1000 W 4 nm/min. Um eine Lagendicke von 4,5 nm zu erreichen, liegt am Ni-Target, wenn die Steuerspannung 0 V beträgt, eine Leistung von 1125 V. Diese Methode hat den Vorteil, dass sowohl die Konzentration als auch die Gesamtschichtdicke bei unveränderter Lagenanzahl praktisch unverändert geblieben sind.

b) Steuerungsmethode b)
Bei dieser Methode wird derart verfahren, dass das Verhältnis der Lagenwiderstände $V_{Ln}$ = 3,15 bzw. $1/V_{Ln}$ = 0,317 möglichst konstant bleibt und die Beschichtung solange fortgeführt wird, bis der gewünschte Endwiderstand erreicht ist.

Im beschriebenen Beispiel trat eine konstante Änderung der Ni-Leistung ab der 2ten Lage auf (siehe Tabelle III):

| Lage | Gesamtwiderstand bei quadr. Fläche in Ω | | Steuer-spannung in V | Istwert Lagenwiderstand in Ω | $V_{Ln}$ bzw. $1/V_{Ln}$ | Momentane Masse % Cr |
|---|---|---|---|---|---|---|
| | vorher | nachher | | | | |
| Cr 1 | --- | 113,0 | 0 | 113,0 | 3,14 | 47,34 |
| Ni 1 | 113,0 | 27,3 | 0 | 36,0 | | |
| | | | | | 0,310 | 46,66 |
| Cr 2 | 27,3 | 22,1 | 0 | 116,0 | 3,96 | 41,61 |
| Ni 2 | 22,1 | 12,6 | 0 | 29,31 | | |
| Cr 3 | 12,6 | 11,10 | +1,1 | 93,0 | 3,19 | 46,94 |
| Ni 3 | 11,10 | 8,04 | 0 | 29,16 | | |
| | | | | | 0,335 | 48,59 |
| Cr 4 | 8,04 | 7,36 | +1,1 | 87,02 | 2,98 | 48,63 |
| Ni 4 | 7,36 | 5,88 | 0 | 29,24 | | |

Tabelle III: Gesamtwiderstand in Abhängigkeit von der Anzahl der aufgebrachten Cr- bzw. Ni-Lagen

Aufgrund der Tatsache, dass das Cr-Target an die erhöhte Rate der Nickelquelle angepasst wird, sind die nachfolgenden Lagen dicker, so dass bereits bei der 4ten Cr- und Ni-Lage die Beschichtung beendet werden kann, da der gewünschte Endwiderstand von 5,5 Ω nahezu erreicht ist.

Wird das Widerstandsmaterial während der Beschichtung zur Erhöhung der Stabilität mit $O_2$ dotiert, so wird der spezifische elektrische Widerstand von Cr und Ni erhöht, wobei der Anstieg von ρ bei gleichem Sauerstoffpartialdruck für Cr höher ist als für Ni, da Cr eine höhere Affinität zum Sauerstoff besitzt. Nachdem in Vorversuchen wieder der spezifische elektrische Widerstand für das dotierte Cr und Ni der entsprechenden Schichtdicke bestimmt wurde, konnte die Kontrolle und Steuerung der Zusammensetzung wie im ersten Beispiel erfolgen, solange die Sauerstoffzufuhr konstant bleibt, was zum Beispiel mittels eines Massenspektrometers überwacht wird. Sollte sich die Sauerstoffzufuhr trotzdem ändern, was man auch daran erkennen kann, dass sich beide Lagenwiderstände gleichzeitig in gleicher Weise ändern, so bleiben die Leistungen der beiden Beschichtungsquellen konstant und der Sauerstoffpartialdruck wird derart geregelt, dass bei der übernächsten Lage der geforderte Gesamtwiderstand wieder erreicht wird.

*Ausführungsbeispiel 2:*

In diesem Beispiel soll die Regelung bei variabler Konzentration in Abhängigkeit von der Schichtdicke, wie es bei der Herstellung von Diffusionsbarrieren für Metallisierungen von Halbleitern, bei der Abscheidung von lötbaren Kontakten, bzw. bei Leitbahnen, die gegen Elektromigration beständig sind, notwendig ist, gezeigt werden. Im vorliegenden Fall wird eine Al-Schicht aufgebracht, in der zur Vermeidung von Elektromigration bei hohen Stromdichten eine Wolframschicht eingelagert ist. Die Al-Schicht wird durch Zerstäuben eines Al-Targets im Magnetron-Gleichstromverfahren abgeschieden, während das Wolfram durch Hochfrequenz-Dioden-Zerstäuben aufgebracht wird.

Die Gesamtschichtdicke sollte ca. 1 μm betragen, wobei nach 0,5 μm eine 100 nm dicke W-Schicht eingelagert werden sollte. Um Diffusionseffekten vorzubeugen ist es vorteilhaft, die Wolframkonzentration allmählich ansteigen, bzw. abfallen zu lassen.

Bei der Steuerspannung 0 V beträgt die Leistung am Al-Target 8 kW, was einer Rate von 96 nm/min entspricht.

Die Leistung für Wolfram liegt bei der Steuerspannung von 0 V bei 5 kW, wobei sich eine Rate von 15 nm/min ergab. Bei einer Umdrehungszahl von 1 U/min, ergaben sich aus Vorversuchen ein $R_{LAl}$ = 0,552 Ω mit $\rho_{Al}$ = 5,3 μΩ cm bzw. $R_{LW}$ = 6,533 Ω mit $\rho_W$ = 9,8 μΩ cm. Der Beschichtungsablauf ist in Tabelle IV dargestellt.

| Lage | Lagenwiderstand bei quadr. Fläche in Ω | $V_{Ln}$ = $R_{LW}/R_{LAl}$ | Steuerspannung in V | Momentane Konzentration in Masse % Al |
|---|---|---|---|---|
| Al 1 | 0,553 | – | 0 | 100 |
| W | --- | | -5 | |
| Al 2 | 0,552 | – | 0 | 100 |
| W | --- | | -5 | |
| Al 3 | 0,551 | – | 0 | 100 |
| W | --- | | -5 | |
| Al 4 | 0,551 | – | 0 | 100 |
| W 1 | 6,533 | 11,86 | 0 | 47,30 |
| Al 5 | 1,100 | 5,94 | -2,5 | 31,0 |
| W 2 | 6,532 | | 0 | |
| Al 6 | 2,201 | 2,97 | -3,75 | 18,20 |
| W 3 | 6,533 | | -0 | |
| Al 7 | 4,502 | 1,45 | -4,3 | 9,9 |
| W 4 | 6,533 | | 0 | |

| Lage | Lagenwiderstand bei quadr. Fläche in Ω | $V_{Ln}$ = $R_{LW} R_{LAl}$ | Steuerspannung in V | Momentane Konzentration in Masse % Al |
|---|---|---|---|---|
| Al | --- | – | -5 | |
| W 5 | 6,533 | | 0 | 0 |
| Al | --- | – | -5 | |
| W 6 | 6,532 | – | 0 | |
| Al | --- | – | -5 | 0 |
| W 7 | 6,532 | | 0 | |
| Al | --- | – | -5 | |
| W 8 | 6,533 | – | 0 | 0 |
| Al | --- | – | -5 | |
| W 9 | 6,534 | | 0 | |
| Al | --- | – | -5 | 0 |
| W 10 | 6,533 | 1,45 | 0 | 9,9 |
| Al 8 | 4,503 | | -4,3 | |
| W 11 | 6,533 | | 0 | 18,3 |
| Al 9 | 2,200 | 2,97 | -3,75 | |
| W 12 | 6,534 | 5,93 | 0 | 30,98 |
| Al 20 | 1,102 | | -2,5 | |
| W 13 | 6,533 | 11,83 | 0 | 47,25 |
| Al 21 | 0,662 | | 0 | |
| W | --- | – | -5 | 100 |
| Al 22 | 0,552 | – | 0 | |
| W | --- | – | -5 | 100 |
| Al 23 | 0,553 | – | 0 | |
| W | --- | – | -5 | 100 |
| Al 24 | 0,553 | – | 0 | |

Tabelle VI: Lagenwiderstände beim Herstellen einer Al-Schicht mit einer Wolfram-Zwischenschicht

*Ausführungsbeispiel 3:*

Ist eine Legierungskomponente sehr hochohmig (zum Beispiel Si), so muss man eine sogenannte Vorlegierung, die einen geringeren spezifischen elektrischen Widerstand besitzt, verwenden. In diesem Fall erfolgt die Regelung wie im 1. Ausführungsbeispiel.

Bei Materialkombinationen, bei denen die beiden Komponenten sehr leicht ineinander diffundieren, erhält man ebenfalls einen diskreten Widerstandsabfall von Lage zu Lage, wenn die Lagendicke so gering ist, dass bereits während einer Umdrehung die Materialien vollständig ineinander diffundieren können.

Im vorliegenden Beispiel werden Ta-Si-Schichten mit einem Si-Massenanteil von 24% hergestellt. Beide Materialien werden in Gleichstrom-Magnetron-Verfahren zerstäubt. Ausgehend von einer Energieversorgung für beide Targets, wird die Leistung über einen Regelwiderstand so verteilt, dass bei der Steuerspannung 0 V gerade die gewünschte Materialkombination entsteht.

Der Widerstand wird vor und nach der Tantalabscheidung sowie nach der Si-Beschichtung gemessen.

Das Problem bei der Herstellung einer Ta-Si-Schicht definierter Zusammensetzung besteht nun darin, dass eine Änderung des Widerstandes einer ineinander diffundierten Doppellage zwei Ursachen haben kann:

1. Änderung der Leistungsabgabe der gemeinsamen Energieversorgung der beiden Targets;

2. Änderung zum Beispiel der Leistungsaufteilung auf beide Targets bei konstanter Leistungsabgabe der gemeinsamen Energieversorgung.

Im Fall 1 erfolgt die Regelung derart, dass zum Beispiel bei einer Erhöhung des Widerstandes einer Doppellage kontrolliert wird, ob sich auch der Lagenwiderstand von Tantal erhöht hat. Ist dies der Fall, so wird zunächst angenommen, dass sich die Leistungsabgabe der gemeinsamen Energieversorgung der beiden Targets verringert hat. Dies kann insofern noch überprüft werden, da bei konstanter Zusammensetzung der Widerstand der Doppellage für die entsprechend verringerte Schichtdicke errechnet und dieser errechnete Wert mit dem gemessenen Widerstand der Doppellage verglichen werden kann. Ist der Unterschied gering, so wird über die erste Steuerspannung nur die Leistung der Energieversorgung solange erhöht (analog Ausführungsbeispiel 1), bis der Lagenwiderstand des Tantals wieder seinen Sollwert erreicht hat. Durch die Koppelung der Leistungsaufteilung erhöht sich auch die Leistung am Si in entsprechender Weise, so dass insgesamt die Zusammensetzung der Schicht konstant bleibt. Analog erfolgt die Regelung, wenn eine Erniedrigung des Widerstandes der Doppellage beobachtet wird.

Im Fall 2 tritt eine Differenz zwischen dem errechneten Widerstand der Doppellage und dem gemessenen Wert auf. Dies bedeutet, dass sich der spezifische elektrische Widerstand der Doppellage und somit die Zusammensetzung der Legierungslage verändert hat, obwohl die gemeinsame Energieversorgung konstante Leistung abgibt.

Da über den Regelwiderstand die Koppelung der Leistungsaufteilung derart ist, dass bei einer Leistungszunahme, zum Beispiel am Si-Target, automatisch die Leistung am Tantaltarget sinkt, muss zur Regelung nur die zweite Steuerspannung dermassen verändert werden, dass sich wieder der geforderte Tantal-Lagenwiderstand einstellt.

*Zu Fall 1:*

Um eine $TaSi_2$-Schicht herzustellen, wird die Leistung bzw. die Leistungsaufteilung so eingestellt, dass pro Umdrehung 5 nm Tantal 11,2 nm Si abgeschieden wird. In Vorversuchen werden die spezifischen elektrischen Widerstände der Tantallage ($\rho_{Ta}$ = 250 μ Ω cm) und der Ta-Si-Doppellage ($\rho_{Ta\text{-}Si}$ = 280 μ Ω cm) ermittelt. Durch die Diffusion beträgt die Schichtdicke der Ta-Si-Doppellage nicht 16,2 nm sondern nur 12,3 nm.

| Lage | Lagen-widerstand bei quadr. Fläche in Ω | spez. elektr. Wider-stand in μ Ω cm | Steuer-span-nung 1 in V | Steuer-span-nung 2 in V |
|---|---|---|---|---|
| Ta 1 | 500,8 | 250,4 | 0 | 0 |
| Ta-Si 1 | 227,6 | 280 | | |
| Ta 2 | 500,1 | 250,25 | 0 | 0 |
| Ta-Si 2 | 227,5 | 279,8 | | |
| Ta 3 | 600,3 | 249,7 | 0 | 0 |
| Ta-Si 3 | 274,5 | 280 | | |
| Ta 4 | 500,3 | 250,1 | + 0,7 | 0 |
| Ta-Si 4 | 227,1 | 279,3 | | |
| Ta 5 | 500,9 | 250,4 | + 0,7 | 0 |
| Ta-Si 5 | 228,0 | 280,4 | | |

Die bei der Lage Ta 3 auftretende Verringerung der Leistung, wird aufgrund der Tatsache, dass sich für die Doppellage der geforderte $\rho$-Wert ergibt, als Verringerung der gemeinsamen Energieversorgung erkannt. Durch die Steuerspannung 1 wird die Energieversorgung so geregelt, dass wieder der gewünschte Lagenwiderstand erreicht wird.

*Zu Fall 2:*

Die Beschichtungsbedingungen sind identisch zu Fall 1. Bei der Lage Ta 3 wird wieder eine Änderung der Ta-Rate festgestellt, die aufgrund des erhöhten $\rho$-Wertes der Doppellage Ta-Si 3 als Konzentrationsänderung, das heisst, als Änderung der Leistungsaufteilung erkannt wird. Der Anstieg von $\rho$ weist auf eine Zunahme des Si-Gehaltes und wegen der Koppelung der Targets auf eine Abnahme des Ta-Gehaltes hin.

Durch die Steuerspannung 2 wird die Leistungsaufteilung wieder so geregelt, dass die ursprünglichen Lagenwiderstände erreicht werden. Eine Nachregelung der Primärenergie ist in diesem Fall nicht notwendig.

| Lage | Lagen-widerstand bei quadr. Fläche in Ω | spez. elektr. Wider-stand in μ Ω cm | Steuer-span-nung 1 in V | Steuer-span-nung 2 in V |
|---|---|---|---|---|
| Ta 1 | 500,1 | 250, | 0 | 0 |
| Ta-Si 1 | 227,0 | 279,2 | | |
| Ta 2 | 500,6 | 250,3 | 0 | 0 |
| Ta-Si 2 | 227,4 | 279,7 | | |
| Ta 3 | 573,2 | 249,9 | 0 | 0 |
| Ta-Si 3 | 273,2 | 311 | | |
| Ta 4 | 500,9 | 250,4 | 0 | –0,65 |
| Ta-Si 4 | 227,8 | 280,2 | | |
| Ta 5 | 500,7 | 250,3 | 0 | –0,65 |
| Ta-Si 5 | 227,1 | 279,3 | | |

## Patentansprüche

1. Verfahren zur Kontrolle und Regelung der Zusammensetzung und der Schichtdicke von metallisch leitenden Legierungsschichten (2) während ihrer Herstellung durch elektrische Widerstandsmessung, wobei die einzelnen Legierungskomponenten (A, B) zeitlich nacheinander zyklisch lagenweise abgeschieden werden, dadurch gekennzeichnet, dass
a) der Schichtwiderstand vor und nach dem Abscheiden jeder einzelnen Lage (A, B) gemessen und dabei der Lagenwiderstand bzw. des Verhältnis der Lagenwiderstände von Schichten mit unterschiedlichem Material als Istwert bestimmt wird,
b) der Lagenwiderstand verglichen wird mit dem vor der Schichtherstellung festgelegten Wert des Lagenwiderstandes bzw. des Verhältnisses der Lagenwiderstände als Sollwert und
c) bei Soll-Istwert-Differenzen die Beschichtungsraten der entsprechenden Legierungskomponentenquellen (A, B) solange verändert werden, bis die Istwerte mit den Sollwerten übereinstimmen.

2. Verfahren nach Anspruch 1, dadurch gekennzeichnet, dass in Abänderung des Verfahrens keine Regelung nach Verfahrensschritt b) und c) durchgeführt wird und nur zur Kontrolle der Schichtzusammensetzung Verfahrensschritt a) durchgeführt wird.

3. Verfahren nach Anspruch 1 und/oder 2, dadurch gekennzeichnet, dass die Messung bei einer Lagendicke kleiner 150 nm, vorzugsweise kleiner 50 nm, durchgeführt wird.

4. Verfahren nach einem der Ansprüche 1 bis 3, dadurch gekennzeichnet, dass die Widerstandsmesswerte drahtlos durch ein Telemetrie-System im Pulscodemodulations(PCM)-Verfahren übertragen werden.

5. Verfahren nach einem der Ansprüche 1 bis 4, dadurch gekennzeichnet, dass die Messwerte über einen Prozessrechner erfasst und berechnet werden.

6. Anwendung des Verfahrens nach einem der Ansprüche 1 bis 5 zur Herstellung von Legierungsschichten mit einer sich über die Schichtdicke kontinuierlich oder diskontinuierlich ändernden Zusammensetzung.

7. Anwendung des Verfahrens nach einem der Ansprüche 1 bis 6 zur Herstellung von binären Aufdampf- oder Aufstäubungslegierungsschichten.

8. Anwendung des Verfahrens nach einem der Ansprüche 1 bis 7 zur Herstellung von Legierungsschichten aus Chrom-Nickel, Chrom-Nickel-Sauerstoff, Tantal-Silizium, Titan-Silizium, Molybdän-Silizium, Aluminium-Silizium, Chrom-Silizium, sowie Doppelschichten aus Silizium-Tantalsilizid, Silizium-Titansilizid, Silizium-Molybdänsilizid, Silizium-Aluminiumsilizid, Silizium-Wolframsilizid, Silizium-Titan mit Aluminium, Silizium-Kupfer mit Aluminium und Chrom-Silizium-Sauerstoff-Schichten.

## Claims

1. A process for controlling and regulating by electrical resistance measurement the composition and thickness of metallically conductive alloy coatings (2) during the production thereof, wherein the individual alloy components (A, B) are deposited layerwise cyclically in succession, characterised in that:
a) the resistance of the coating is measured before and after the deposition of each individual layer (A, B) and the layer resistance, or the ratio of the layer resistances of layers consisting of different materials, is determined as actual value,
b) the layer resistance is compared with the value of the layer resistance or the ratio of the resistances determined prior to the production of the coating, as theoretical value,
c) in the case of the differences between the theoretical value and the actual value, the coating rates of the corresponding alloy component sources (A, B) are changed until the actual values conform with the theoretical values.

2. A process as claimed in claim 1, characterised in that in a modification of the process, no regulation is carried out in accordance with process steps (b) and (c) and process step (a) is performed only to control the composition of the coating.

3. A process as claimed in claim 1 and/or 2, characterised in that the measurement is carried out at a layer thickness of less than 150 nm preferably less than 50 nm.

4. A process as claimed in one of claims 1 to 3, characterised in that the measured values are transmitted by radio by means of a telemetry system resistance using pulse code modulation (PCM).

5. A process as claimed in one of claims 1 to 4, characterised in that the measured values are detected and calculated by way of a process computer.

6. The application of the process claimed in one of claims 1 to 5 for the production of alloy coatings whose composition changes continuously or discontinuosly across the coating thickness.

7. The application of the process claimed in one of claims 1 to 6 for the production of binary, vapour-deposited, or sputtered, alloy coatings.

8. The application of the process claimed in one of claims 1 to 7 for the production of alloy coatings consisting of chromium-nickel-oxygen, tantalum-silicon, titanium-silicon, molybdenum-silicon, aluminium-silicon, chromium-silicon, and double layers consisting of silicon-tantalum silicide, silicon-titanium silicide, silicon molybdenum silicide, silicon-aluminium silicide, silicon-tungsten silicide, silicon-titanium with aluminium, silicon-copper with aluminium and chromium-silicon-oxygen coatings.

## Revendications

1. Procédé pour contrôler et régler la composition et l'épaisseur de couches d'alliages métalliques conducteurs (2), pendant la fabrication au moyen d'une mesure électrique de résistance, les différents constituants (A, B) de l'alliage étant déposés successivement et cycliquement par couches, caractérisé par le fait que:
a) on mesure la résistance de couche avant et après le dépôt de chaque couche individuelle (A, B) et on détermine la résistance de couche ou le rapport des résistances des couches avec un autre matériau, en tant que valeur réelle,

b) on compare la résistance de couche à la valeur, déterminée par la fabrication des couches, de la résistance de couche ou du rapport des résistances de couche en tant que valeur de consigne, et

c) dans le cas de différences entre la valeur de consigne et la valeur réelle, on modifie les vitesses d'enduction fournies par les sources correspondantes des constituants de l'alliage (A, B) jusqu'à ce que la valeur réelle coïncide avec la valeur de consigne.

2. Procédé suivant la revendication 1, caractérisé par le fait que, à titre de variante du procédé, on n'exécute aucun réglage après les phases opératoires b) et c) et on met en oeuvre la phase opératoire a) uniquement pour contrôler la composition des couches.

3. Procédé suivant la revendication 1 et/ou 2, caractérisé en ce que l'on effectue la mesure pour une épaisseur de couche inférieure à 150 nm et de préférence inférieure à 50 nm.

4. Procédé suivant l'une des revendications 1 à 3, caractérisé par le fait que les valeurs de mesure de la résistance sont transmises sans fil par un système de télémétrie, selon le procédé de modulation par impulsions codées (MIC).

5. Procédé suivant l'une des revendications 1 à 4, caractérisé par le fait que les valeurs de mesure sont déterminées et détectées par l'intermédiaire d'un calculateur de processus.

6. Application du procédé suivant l'une des revendications 1 à 5 à la fabrication de couches d'alliage possédant une composition variable de façon continue ou discontinue sur l'épaisseur de la couche.

7. Application du procédé suivant l'une des revendications 1 à 6 à la fabrication de couches d'alliages binaires déposées par évaporation ou pulvérisation.

8. Application du procédé suivant l'une des revendications 1 à 7 à la fabrication de couches d'alliage de chrome-nickel, chrome-nickel-oxygène, tantale-silicium, titane-silicium, molybdène-silicium, aluminium-silicium, chrome-silicium, ainsi que de couches doubles de silicium-siliciure de tantale, silicium-siliciure de titane, silicium-siliciure de molybdène, silicium-siliciure d'aluminium, silicium-siliciure de tungstène, silicium-titane avec aluminium. silicium-cuivre avec aluminium et des couches de chrome-silicium-oxygène.

FIG 1

FIG 2

FIG 3

FIG 4